(19) Europäisches Patentamt
European Patent Office
Office européen des brevets

(11) **EP 2 530 495 A1**

(12) **EUROPEAN PATENT APPLICATION**
published in accordance with Art. 153(4) EPC

(43) Date of publication:
**05.12.2012 Bulletin 2012/49**

(51) Int Cl.:
*G02B 5/08* (2006.01)   *B32B 15/01* (2006.01)
*B32B 15/04* (2006.01)   *C23C 14/14* (2006.01)
*C23C 14/58* (2006.01)   *F21V 7/22* (2006.01)

(21) Application number: **11734813.6**

(22) Date of filing: **25.01.2011**

(86) International application number:
**PCT/JP2011/051337**

(87) International publication number:
**WO 2011/090207 (28.07.2011 Gazette 2011/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.01.2010   JP 2010013492**

(71) Applicant: **Kabushiki Kaisha Kobe Seiko Sho
Kobe-shi, Hyogo 651-8585 (JP)**

(72) Inventors:
• **KATSURA Sho**
**Kobe-shi**
**Hyogo 651-2271 (JP)**

• **SUZUKI Jun**
**Kobe-shi**
**Hyogo 651-2271 (JP)**
• **KOBAYASHI Nobuhiro**
**Kobe-shi**
**Hyogo 651-2271 (JP)**
• **SATO Toshiki**
**Kobe-shi**
**Hyogo 651-2271 (JP)**

(74) Representative: **Müller-Boré & Partner
Patentanwälte
Grafinger Straße 2
81671 München (DE)**

(54) **REFLECTIVE FILM LAMINATE**

(57)     Disclosed is a reflective film laminate, which has a pure Ag film or an Ag-based alloy film as a first layer on a base body, and an oxide film of a metal of one or more kinds selected from among Zr, Cr, Nb, Hf, Ta, V, Ni, Mo, W, Al and Si, as a second layer on the first layer. The thickness of the second layer is 0.1 to 10 nm, and deterioration of the reflection ratio of reflective film laminate is 30% or less by having the second layer provided therein. The reflective film laminate is provided with a protection film, which has a high initial reflection ratio, excellent sulfuration resistance and heat resistance, and an extremely small number of pin holes. As a result, the reflection ratio of the reflective film laminate is not easily deteriorated due to aggregation of Ag atoms of the Ag film.

F I G . 2

EP 2 530 495 A1

**Description**

Technical Field

The present invention relates to a reflective film laminate, and a lighting tool for a vehicle, an illuminator, or an optical mirror that has this reflective film laminate.

Background Art

A pure Ag film or an Ag-based alloy film, which may be referred to as an Ag film hereinafter, comes to give a high reflectivity (reflection ratio) against visible rays when the film has a film thickness of 70 nm or more. Thus, the Ag film is widely used as a reflective film for a vehicle in which a light source that may be of various types, such as a halogen lamp, an HID or an LED, is used. However, Ag atoms in the Ag film have a property of aggregating easily; thus, the front surface of the Ag film is made rough by the aggregation, so that the film may be lowered in reflectivity.

Examples of the cause of the aggregation of the Ag atoms include the adsorption of sulfur or some other in the atmosphere onto the Ag film front surface, and the exposure of the reflective film to a high-temperature environment of about 80 to 200°C temperature by heat radiated from various light sources.

In order to solve the problem, techniques have been hitherto developed in each of which a protective film is formed on an Ag film to shield the Ag film from any external environment. For example, Patent Literature 1 discloses a lighting tool for a vehicle in which a protective film made of a modified silicone resin is formed on an Ag film. Patent Literature 2 discloses a reflective film having, on an Ag film, a protective film made of a metal oxide such as ITO. Patent Literature 3 discloses a reflective film in which a protective film that is a titanium film or titanium alloy film is formed on an Ag film. Patent Literatures 4 and 5 each disclose a reflective film in which a layer of a metal oxide of Si, Al or Ti is formed on an Ag film containing Bi or some other element.

However, even when the protective film is made of a modified silicone resin as disclosed in Patent Literature 1, sulfur or some other component may diffuse or penetrate into the resin, or the resin material may be deteriorated in a high-temperature environment. Even when the protective film is made of a metal oxide such as ITO, or is rendered a titanium film or titanium alloy film as disclosed in Patent Literature 2 or 3, sulfur or some other component may invade the reflective film through pinholes in the protective film. As a result, the Ag atoms aggregate so that many white dots or discolorations are generated in the Ag film front surface, so that the reflective film may be declined in reflectivity or the product concerned may be deteriorated in design or merchandise performance, or some other performance. According to Patent Literature 4 or 5, a metal oxide film is formed as the protective film. However, at the time of the formation, a sputtering target made of the metal oxide is used. Thus, pinholes may be made in the metal oxide layer.

When a protective film is formed on an Ag film, the high reflectivity of the Ag film may be declined.

Accordingly, when an attempt is made for preventing a decline in the reflectivity of an Ag film through a protective film, properties required for the protective film are as follows: the protective film does not easily make the high reflectivity of the Ag film low; the protective film itself has an excellent sulfurization resistance and heat resistance; sulfur and some other component do not diffuse or penetrate into the protective film; and the protective film has no pinholes.

Citation List

Patent Literatures

Patent Literature 1: JP 2000-106017 A

Patent Literature 2: JP 2006-98856 A

Patent Literature 3: JP 2008-191528 A

Patent Literature 4: JP 2008-233894 A

Patent Literature 5: JP 2009-98650 A

Summary of the Invention

Technical Problems

Under a situation as described above, the present invention has been made. An object of the invention is to provide a reflective film laminate formed to have an Ag film, and having a protective film which is high in initial reflectivity and excellent in sulfurization resistance and heat resistance, and which is made as small as possible in the number of pinholes, so that the reflective film laminate does not easily undergo a decline in reflectivity that is caused by the aggregation of Ag atoms in the Ag film.

Solution to the Problems

The reflective film laminate of the invention that has solved the above-mentioned problems is a reflective film laminate comprising a substrate, a pure Ag film or an Ag-based alloy film as a first layer over the substrate, and an oxide film as a second layer laid over the first layer, the oxide film being an oxide film of one or more metals selected from the group consisting of Zr, Cr, Nb, Hf, Ta, V, Ni, Mo, W, Al and Si, in which the second layer has a thickness of 0.1 to 10 nm, and further by the laying of the second layer, the reflectivity of the reflective film laminate is deteriorated by 30% or less.

In the present specification, the wording "over the substrate" or "over the (first) layer" includes, as the meaning thereof, a case where the first layer is laid directly on the substrate, or the second layer is laid directly on the first layer; and a case where the first layer or the second layer is laid over the substrate or the first layer to interpose any other layer therebetween.

In a preferred embodiment of the reflective film laminate of the invention, the first layer has an average crystal grain diameter of 100 nm or less. In a preferred embodiment of the reflective film laminate of the invention, the first layer is an Ag-based alloy film comprising Bi in a proportion of 0.02 atomic percent or more; the first layer is the Ag-based alloy film that further comprises Ge in a proportion of 0.02 atomic percent or more; the first layer is the Ag-based alloy film that further comprises one or more selected from the group consisting of Au, Pt, Pd, and Rh in a proportion of 0.1 to 5 atomic percent; or the first layer is the Ag-based alloy film that further comprises one or more selected from the group consisting of Cu, Sn, Al, Cr, V, Mo, Ru, Ir and Si in a proportion of 0.1 atomic percent or more. In the preferred embodiment, in particular, the first layer is an Ag-based alloy that comprises one or more selected from the group consisting of Cu, Sn and Al in a proportion of 0.1 atomic percent or more.

An additional preferred embodiment of the reflective film laminate of the invention has, as the second layer, an oxide film of one or more metals selected from the group consisting of Zr, Cr, Nb, and Ta; or the laminate has a plasma polymerized film or a resin film as a third layer over the second layer.

The invention includes, as one aspect thereof, a method for producing the above-mentioned reflective film laminate comprising the step of forming the above-mentioned first layer over a substrate, and the step of using a sputtering target comprising the above-mentioned metal(s) to perform sputtering over the first layer, thereby forming a sputtered thin film, and next oxidizing the sputtered thin film in an atmosphere containing oxygen, thereby forming the above-mentioned second layer.

In the specification, the word "oxidizing" includes, as the meaning thereof, a case where the sputtered thin film is intentionally oxidized in an atmosphere containing oxygen, and a case where a laminate comprising the sputtered thin film formed over the first layer is merely allowed to stand still in an atmosphere containing oxygen, so that the sputtered thin film is oxidized.

According to the invention, at the time of forming, over the first layer, the second layer comprising the oxide film of the predetermined metal(s), the sputtering target of the above-mentioned metal(s), which is not a sputtering target of any metal oxide, is used to perform sputtering to form a thin film, and next this thin film is oxidized. It is therefore possible to gain an effect of closing or stopping pinholes by volume-expansion generated when the metal(s) is/are oxidized.

The invention further includes, as aspects thereof, a light tool for a vehicle, an illuminator, and an optical mirror that each comprise the above-mentioned reflective film laminate.

Advantageous Effects of the Invention

In the reflective film laminate of the invention, the Ag film (the first layer), which exhibits a high reflectivity, is protected by the oxide film (the second layer) of the predetermined metal(s), which exhibits endurance against sulfur and heat. Thus, the reflective film laminate is excellent in sulfurization resistance and heat resistance. Moreover, the deterioration (the deterioration ratio) in the reflectivity of the reflective film laminate, which is caused by laying the second layer, is restrained into 30% or less, so that the reflective film laminate is high in initial reflectivity. It is therefore expected that the reflective film laminate keeps a high reflectivity over a long term. Additionally, according to the matter that the high reflectivity can be kept over a long term, the following is expected: when the reflective film laminate of the invention is used as a lighting tool for a vehicle, an illuminator or an optical mirror, the endurance thereof is improved.

Brief Description of the Drawings

Fig. 1 is an AFM (atomic force microscopic) image of a first layer yielded in Production Example 37.
Fig. 2 is an AFM (atomic force microscopic) image of a first layer yielded in Production Example 3.
Fig. 3 is a schematic view illustrating an example of a reflective film laminate in which a second layer is laminated (or stacked), this layer being composed of a (topmost) surface that is sufficiently oxidized, and a metal film (metal layer) that is not sufficiently oxidized.

Best Mode for Carrying Out the Invention

The reflective film laminate of the invention is a reflective film laminate including a substrate, a pure Ag film or an Ag-based alloy film as a first layer over the substrate, and an oxide film as a second layer laid over the first layer, the oxide film being an oxide film of one or more metals selected from the group consisting of Zr, Cr, Nb, Hf, Ta, V, Ni, Mo, W, Al and Si, in which the second layer has a thickness of 0.1 to 10 nm, and further by the laying of the second layer, the reflectivity of the reflective film laminate is deteriorated by 30% or less.

The inventors have made eager investigations to provide a reflective film laminate which includes an Ag film, which has a high reflectivity required for a lighting tool for a vehicle, an illuminator, an optical mirror or some other, and which can further prevent the aggregation of Ag atoms in the Ag film. As a result, the inventors have found out that it is effective to form, over an Ag film, an oxide film of one or more predetermined metals, such as Zr, as a second layer.

Unclear are details of the mechanism that the reflective film laminate of the invention has not only a high initial reflectivity but also an excellent sulfurization resistance and heat resistance. However, the mechanism is assumed as follows:

The oxide layer of the predetermined metal(s), such as Zr, which forms the second layer, does not undergo the diffusion or penetration of sulfur, and the layer itself has an excellent sulfurization resistance and heat resistance. In addition, as will be described later, in the invention, at the time of the formation of the second layer, a metal film of the predetermined metal(s), such as Zr, is beforehand formed and subsequently the metal film is oxidized to form the metal oxide film; the predetermined metal(s), such as Zr, is/are expanded in volume by the oxidization, and the expansion can be expected to produce an advantageous effect of restraining the formation of pinholes in the metal oxide film (the second layer).

Furthermore, because of the above-mentioned property of the metal oxide film (the second layer), the thickness of the second layer can be made as small as a value of 0.1 to 10 nm. Thus, even when the second layer is laid, the high reflectivity of the Ag film can be prevented from being deteriorated. Specifically, about the reflectivity (the reflectivity of only the first layer, the reflectivity of the reflective film laminate after the lamination of the second layer), the deterioration by the laying of the second layer can be restrained into 30% or less.

Hereinafter, the reflective film laminate of the invention will be described in detail.

First Layer:

First, a description will be made about the Ag film (the first layer) that the reflective film laminate of the invention has. The first layer that the invention has is a layer for causing the laminate to exhibit a high reflectivity, and is formed as a pure Ag film or an Ag-based alloy film.

A pure Ag film shows a very high reflectivity of about 96% when the film thickness thereof is 70 nm or more. However, when any pure Ag film is exposed to high temperature, the film may undergo aggregation (of atoms therein) by heating. Thus, when the reflective film laminate of the invention is used in an atmosphere the temperature of which may turn to 100°C or higher, it is preferred to use an Ag-based alloy film as the first layer. Examples thereof include Ag-based alloy films described in Patent Literatures 2 to 5 described above. A Ag-based alloy film containing Bi is in particular preferably used.

Bi has an effect of restraining the growth of crystal grains of Ag, and the aggregation (of the atoms) of Ag, which are each caused by heat. In order to cause such an effect to be effectively exhibited to improve the heat resistance of the Ag film, the lower limit of the Bi content by percentage in the Ag-based alloy film is set preferably to 0.02 atomic percent (more preferably to 0.03 atomic percent, even more preferably to 0.05 atomic percent, in particular preferably to 0.08 atomic percent). However, when the Bi content by percentage becomes high, the effect of improving the heat resistance is saturated while the reflective film laminate is lowered in reflectivity. Thus, the upper limit of the Bi content by percentage is set preferably to 0.3 atomic percent (more preferably to 0.25 atomic percent, even more preferably to 0.2 atomic percent).

An example of this Ag-based alloy film is a film which contains Bi in the above-mentioned quantity and contains, as the balance, Ag and inevitable impurities.

The Bi-containing Ag-based alloy film, which is used as the first layer in the invention, may further contain an element other than Bi as the Ag-based alloy film described in, for example, Patent Literature 4 or 5 does. Specifically, the Ag-based alloy film that further contains Ge may be used.

In the same manner as Bi, Ge has an effect of restraining the growth of crystal grains of Ag, and the aggregation, which are each caused by heat. Ge also has an effect of heightening the sulfurization resistance of the Ag-based alloy film, and restraining discoloration of the Ag-based alloy film that is caused when the Ag-based alloy film is brought in contact with sulfur in hydrogen sulfide, or some other component that is contained in the air. In order to cause such effects to be effectively exhibited, the lower limit of the Ge content by percentage in the Ag-based alloy film is set preferably to 0.02 atomic percent (more preferably to 0.05 atomic percent, even more preferably to 0.08 atomic percent). The upper limit of the Ge content by percentage is set preferably to 1 atomic percent (more preferably to 0.5 atomic percent). Even if Ge is incorporated into the layer in a content by percentage more than 1 atomic percent, the above-mentioned improvement effect is saturated while the reflective film laminate is lowered in reflectivity.

An example of this Ag-based alloy film is a film which contains Bi and Ge in the above-mentioned respective quantities and contains, as the balance, Ag and inevitable impurities.

The Bi-containing Ag-based alloy film, which is used as the first layer in the invention, may contain, instead of or together with Ge, one or more selected from the group consisting of Au, Pt, Pd and Rh, which may be referred to merely as the "M1 elements" hereinafter. Of the M1 elements, Au, Pt and Pd are preferred, and Au and Pt are more preferred.

The M1 elements each have an effect of restraining the aggregation of Ag atoms that is caused by water or halogens (such as NaCl). In order to cause such an effect to be effectively exhibited, the lower limit of the total content by percentage of one or more of the M1 elements (when the first layer contains one of the M1 elements, the total content is the content by percentage of only the one element; and when the layer contains two or more elements thereof, the total content is the total content by percentage of the two or more elements) is set preferably to 0.1 atomic percent (more preferably to 0.3 atomic percent). The upper limit of the total content by percentage of one or more of the M1 elements (the content by percentage of only the one element or the total content by percentage of the two or more elements) is set preferably to 5 atomic percent (more preferably to 3 atomic percent). If the total content by percentage of one or more of the M1 elements is less than 0.1 atomic percent, the effect of restraining the aggregation of the Ag atoms (the effect of improving the Ag film in humidity resistance and halogen resistance) is small. On the other hand, if the total content by percentage is more than 5 atomic percent, costs may increase, and the Ag film may be lowered in initial reflectivity, humidity resistance, halogen resistance and others.

Examples of this Ag-based alloy film include a film which contains Bi and one or more of the M1 elements in the above-mentioned respective quantities, and contains, as the balance, Ag and inevitable impurities; and a film which contains Bi, Ge and one or more of the M1 elements in the above-mentioned respective quantities, and contains the same balance. In the invention, the latter embodiment is most preferred since the Ag film itself can have an excellent sulfurization resistance and heat resistance.

The Bi-containing Ag-based alloy film, which is used as the first layer in the invention, may contain, instead of or together with Ge and/or one or more of the M1 elements, one or more selected from the group consisting of Cu, Sn, Al, Cr, V, Mo, Ru, Ir and Si, which may be referred to merely as the "M2 elements" hereinafter. Of the M2 elements, preferred are Cu, Sn and Al.

The M2 elements each have a nature of being concentrated in any surface of the Ag-based alloy film. In the reflective film laminate according to the invention, each of the M2 elements that is contained in the first layer receives heat, thereby being diffused and concentrated from the surface of the Ag-based alloy film into the second layer. Thus, by sealing pinholes depending on the second layer, the reflective film laminate is greatly improved in endurance, in particular, heat resistance. In order to cause such an effect to be effectively exhibited, the lower limit of the total content by percentage of one or more of the M2 elements (when the first layer contains one of the M2 elements, the total content is the content by percentage of only the one element; and when the layer contains two or more elements thereof, the total content is the total content by percentage of the two or more elements) is set desirably to 0.1 atomic percent (more preferably to 0.3 atomic percent). The upper limit of the total content by percentage of one or more of the M2 elements (the content by percentage of only the one element or the total content by percentage of the two or more elements) is set preferably to 5 atomic percent (more preferably to 3 atomic percent). If the total content by percentage of one or more of the M2 elements is less than 0.1 atomic percent, the quantity of the one or more of the M2 elements concentrated into the second layer is small so that the effect of sealing pinholes in the second layer is small. On the other hand, if the total content by percentage is more than 5 atomic percent, costs may increase or the reflective film laminate may be lowered in initial reflectivity.

This Ag-based alloy film is, for example, a film which contains Bi and one or more of the M2 elements in the above-mentioned respective quantities, contains Bi, Ge and one or more of the M2 elements in the above-mentioned respective quantities, or contains Bi, Ge, one or more of the M1 elements, and one or more of the M2 elements in the above-mentioned respective quantities; and which further contains, as the balance, Ag and inevitable impurities. In the invention, most preferred is a film which contains Bi, Ge, one or more of the M1 elements and one or more of the M2 elements in the above-mentioned respective quantities; and which contains, as the balance, Ag and inevitable impurities since the Ag film itself can have an excellent sulfurization resistance and heat resistance, and can make a further improvement in the protecting performance of the protective film.

Average Crystal Grain Diameter:

The first layer that the invention has is preferably controlled to have an average crystal grain diameter of 100 nm or less.

As will be described later, by volume-expansion based on the oxidization of the predetermined metal(s), such as Zr, in the invention, the formation of pinholes in the metal oxide film (the second layer) is restrained. However, the volume-expansion based on the oxidization of the metal(s) has a limitation. Thus, when the film of the metal(s) formed on the first layer before the oxidization is low in nucleus generation density, the formation of the pinholes may be unable to be sufficiently restrained even by the volume-expansion. However, it is assumed that when the average crystal grain diameter of the first layer is controlled into 100 nm or less to make the crystal grains fine and dense, the film of the metal (s) can be made high in nucleus generation density. As a result, the pinhole-sealing effect based on the volume-expansion of the metal(s) can be sufficiently expected. The pinhole-sealing effect makes a sufficient improvement of the reflective film laminate in sulfurization resistance and heat resistance even when the film thickness of the second layer is made small (0.1 to 10 nm). Thus, the laminate can be restrained from being lowered in initial reflectivity without needing to make the second layer thick.

As the average crystal grain diameter of the first layer is smaller, a more favorable result is obtained. The diameter is preferably 90 nm or less, more preferably 80 nm or less, even more preferably 60 nm or less. If the average crystal grain diameter of the first layer is more than 100 nm, the resultant sulfurization resistance and heat resistance of the reflective film laminate may not be sufficiently improved. The reason therefor is assumed as follows: if the crystal average grain diameter of the first layer is more than 100 nm, the metal film (before oxidized) formed on the first layer is lowered in nucleus generation density so that the volume-expansion generated at the time of oxidizing the metal film does not give a sufficient pinhole-sealing effect. The lower limit of the average crystal grain diameter of the first layer is not particularly limited, and is preferably 15 nm from the viewpoint of production costs.

About the method for controlling the average crystal grain diameter of the first layer into the above-mentioned range, and the method for measuring the diameter, a description will be made later.

Second Layer:

The second layer that the invention has is a layer for causing the reflective film laminate to exhibit endurance against heat and sulfur, and is characterized by being an oxide film of one or more metals selected from the group consisting of Zr, Cr, Nb, Hf, Ta, V, Ni, Mo, W, Al and Si.

The metal or each of the metals that constitute the second layer is a component selected as a metal having a PB ratio (pilling-bedworth ratio: "the volume of the metal oxide per unit mole" / "that of the metal per unit mole") more than 1 so as to be expanded in volume when oxidized. The metal can be expected to give an effect of restraining the formation of pinholes when oxidized. Moreover, the metal oxide thereof itself is excellent in endurance, so that it hardly occurs that the second layer is deteriorated and the Ag film (the first layer) is also deteriorated accordingly. The metal damages the high reflectivity of the Ag film as the first layer, which is a characteristic of this film, when the metal is in a metal film state; however, when the metal is made into the oxide, the metal becomes transparent. Thus, the metal oxide can prevent a decline in the reflectivity of the Ag film. In a case where the metal(s) constituting the second layer has/ have a PB ratio more than 1 as described above, the metal(s) is/are expanded in volume when oxidized, so as to produce an advantageous effect of sealing pinholes. However, when the PB ratio of the metal(s) is close to 1, the pinhole-sealing effect of the metal(s) is small. Thus, the PB ratio is preferably 1.3 or more. In the meantime, when the PB ratio of the metal(s) is extremely large, the metal(s) is/are largely expanded in volume when oxidized. The expansion easily causes the protective film to be easily cracked so that the protecting performance thereof may be declined. Thus, the PB ratio is preferably 4.0 or less (more preferably 3.5 or less, even more preferably 3.0 or less). From this viewpoint, it is preferred in the invention to use, out of the above-mentioned metals, one or more selected from the group consisting of Zr, Cr, Nb, Ta and Ni.

In the invention, the film thickness of the second layer is set to 0.1 nm or more (preferably 0.15 nm or more, more preferably 0.2 nm or more), and 10 nm or less (preferably 7 nm or less, more preferably 5 nm or less). When the film thickness of the second layer is in this range, a metal oxide film (as the second layer) can be obtained in which the metal is oxidized over the whole in the film thickness direction of the film. Thus, the second layer can be made transparent to prevent a decline in the initial reflectivity of the reflective film laminate of the invention. Specifically, by the laying of the second layer, the deterioration in the reflectivity of the laminate can be restrained to 30% or less (preferably 15% or less, more preferably 5% or less, even more preferably 0.5% or less). If the deterioration in the reflectivity is more than 30%, the reflective film laminate of the invention is lowered in initial reflectivity, so that the laminate may be unable to be used for articles for which a high reflectivity is required.

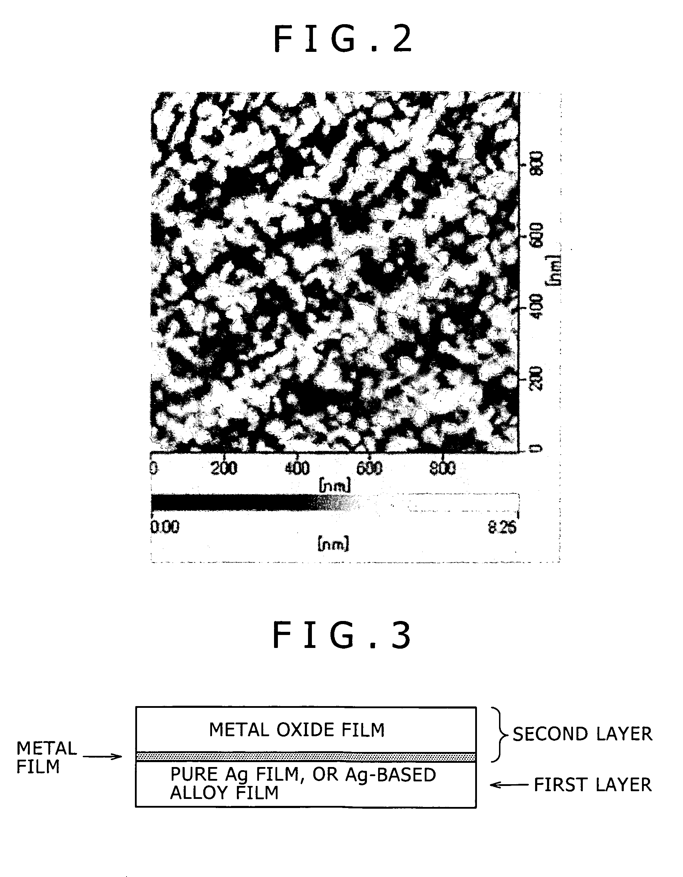

The second layer is preferably a layer that is sufficiently oxidized over the whole in the film thickness direction of the film. However, the second layer is not limited to this layer as far as the effect that the deterioration in the reflectivity is restrained into 30% or less by the laying of the second layer is exhibited. As illustrated in, for example, Fig. 3, the second layer may be composed of a (topmost) surface that is sufficiently oxidized, and a metal film (metal layer) that is not sufficiently oxidized. Alternatively, the second layer may be an embodiment in which from the second layer (topmost) surface, the concentration of the metal oxide gradually becomes lower in the film thickness direction.

When the second layer is formed over the first layer having an average crystal grain diameter of 100 nm or less, the effect of sealing pinholes by the oxidization is sufficiently obtained; thus, even when the film thickness of the second layer is set into the above-mentioned range, the reflective film laminate easily comes to exhibit an excellent sulfurization resistance and heat resistance.

If the film thickness of the second layer is less than 0.1 nm, the above-mentioned improvement effect by the laying of the second layer may be unable to be sufficiently exhibited. As the film thickness of the second layer becomes larger, the pinhole size becomes smaller. Thus, it is conceivable that pinholes in the oxide film become able to be sealed. However, the second layer is not easily oxidized over the whole thereof in the film thickness direction, so that the second layer is not made transparent. Thus, the initial reflectivity of the reflective film laminate of the invention may be deteriorated.

Third Layer:

The reflective film laminate of the invention may have, over the second layer thereof, a plasma polymerized film or a resin film.

When the plasma polymerized film is formed by use of, for example, an organic silicon, the reflective film laminate of the invention can be made higher in endurance so that the laminate can keep the high reflectivity thereof over a longer term. Examples of this organic silicon include hexamethyldisiloxane, hexamethyldisilazane, and triethoxysilane.

The film thickness of the plasma polymerized film is preferably from 5 to 500 nm, more preferably from 10 to 400 nm. If the film thickness is made small, the film becomes low in barrier performance. On the other hand, if the film thickness is made larger, the stress of the film becomes large; thus, after stacked and formed, the plasma polymerized film may be cracked or peeled when the reflective film laminate is caused to undergo a heat resistance test or a humidity resistance test.

Examples of the resin material that forms the resin film include acrylic resin, and silicone resin. The film thickness of the resin layer is preferably from 0.1 to 20 $\mu$m. If the film thickness is outside this range, the same problems as described above may be caused.

Substrate:

The material of the substrate used in the reflective film laminate of the invention is not particularly limited. The material is not particularly limited as far as the material is a material that is ordinarily used in the field of illuminators, lighting tools for vehicles, and others that each have an Ag film. The material is, for example, a resin, or glass. Examples of the resin include polycarbonate resin, acrylic resin, polyester resins such as PET (polyethylene terephthalate) and PBT (polybutylene terephthalate), ABS resin, epoxy resin, acetal resin, and alicyclic hydrocarbon resins. These resins may be used in a mixture form.

It is preferred in the invention that the material of the substrate is decided in accordance with the temperature of heat radiated from the light source (concerned). When the temperature of the light source is, for example, about 180°C or higher, the use of glass is preferred. When the temperature is from about 120 to 180°C, a polyester resin, such as PET or PBT, is preferred. When the temperature is about 120°C or lower, the use of polycarbonate resin is preferred.

Use may be made of a resin material having a water absorption less than 0.1%, the absorption being obtained when a measurement is made according to the A method prescribed in JIS K 7209 (method of immersing the material in pure water of 23°C temperature for 24 hours, and then measuring the amount of absorbed water). When use is made of such a substrate excellent in moisture proof (waterproof) (substrate small in water absorption), it is possible to prevent the aggregation in the Ag film, which is caused by water contained in the substrate, or water that has invaded the substrate from the substrate surface on which no Ag film is formed (the rear surface). Thus, a reflective film laminate excellent in moisture proof can be yielded.

Examples of the resin satisfying the above-mentioned requirement include PET resin (water absorption: 0.05%), and PPS (polyphenylene sulfide) resin (water absorption: 0.03%). The water absorption of the substrate is preferably 0.08% or less, more preferably 0.06% or less.

Properties and Usage of Reflective Film Laminate:

The reflective film laminate of the invention has the oxide film (the second layer) of the predetermined metal (s), such as Zr, on the first layer, which is an Ag film. Thus, even when the film thickness of the second layer is made small (0.1 to 10 nm), this layer can obtain the effect of sealing pinholes so that the laminate can exhibit an excellent sulfurization resistance and heat resistance, and a high reflectivity.

It is Al which is ordinarily used as a material of a reflective film of a lighting tool for a vehicle, an illuminator, or an optical mirror. The reflectivity thereof is about 85%. In contrast thereto, the reflective film laminate of the invention is very high in reflectivity. The visible ray reflectivity thereof can be made higher than any laminate in which Al is used as a reflective film material, this reflectivity being measured according to JIS R 3106 using light rays having wavelengths in the range of 380 to 780 nm from a D65 light source. Accordingly, when the reflective film laminate of the invention is used for a lighting tool for a vehicle, an illuminator, or an optical mirror, this member or the member concerned can keep brightness substantially equal to any conventional equivalent member even when the light source (lamp) of the former member is made lower in consumption power than that of the latter member. When plural lamps are used, the number of the lamps can be decreased. Thus, costs used for the light sources can be reduced.

The wording "lighting tool for a vehicle" denotes a head lamp, a rear lamp or the like of an automobile or motorcycle. The reflective film laminate of the invention is favorably used for a reflecting plate or extension of such a lamp. The word "illuminator" denotes a down-light, a fluorescent lamp, or the like. Examples of the illuminator include any illuminator in which an LED or an organic EL is used as its light source. The wording "optical mirror" denotes a mirror of a flash unit of a camera, a mirror inside an analyzing device using the reflection of light, or the like.

Method for Producing Reflective Film Laminate of the Invention:

In order that the second layer (oxide film) that the invention has can exhibit a sufficient pinhole-sealing effect when the film thickness thereof is from 0.1 to 10 nm, the production of the reflective film laminate of the invention is preferably attained, as described above, by forming a metal film of the predetermined metal(s), such as Zr, beforehand onto a first layer (Ag film), and next oxidizing this metal film to be turned to an oxide film (to form a second layer). At this time, about the first layer, it is preferred to control the average crystal grain diameter into 100 nm or less.

By the formation of the metal oxide film as the second layer by the oxidization after the formation of the film of the metal(s), such as Zr, the pinhole-sealing effect based on the volume-expansion at the time of the oxidization is effectually exhibited. On the other hand, when a sputtering target made of a metal oxide is used to form a second layer as disclosed in Patent Literature 4 or 5 described above, a desired pinhole-sealing effect is not obtained. For example, Patent Literature 4 describes, as a comparative example, a laminate which overlaps with the invention in composition. The literature detailedly describes a laminate in which a $ZrO_2$ (second layer) of 20 nm thickness was formed on an Ag-based alloy film (first layer) containing 1.0 atomic percent of Bi and 1.0 atomic percent of Ge. However, it is stated that this laminate was poor in sulfurization resistance and heat resistance. The reason therefor is assumed as follows: the second layer was formed, using a sputtering target of $ZrO_2$; thus, the volume-expansion effect at the time of the metal oxidization was not effectually exhibited.

The method for producing the reflective film laminate of the invention may be, for example, a producing method including the step of forming the above-mentioned first layer over a substrate, and the step of using a sputtering target comprising the above-mentioned metal(s) to perform sputtering over the first layer, thereby forming a sputtered thin film, and next oxidizing the sputtered thin film in an atmosphere containing oxygen, thereby forming the above-mentioned second layer. Hereinafter, a description will be made about this reflective film laminate producing method.

The manner for forming an Ag film that constitutes the first layer may be a manner of using a pure-Ag sputtering target or Ag-based-alloy sputtering target to deposit the film by sputtering. It is particularly preferred to deposit the film by DC sputtering using a direct-current cathode. It is preferred in the invention to adjust the substrate temperature (film-depositing temperature) appropriately in accordance with the species of the sputtering target in order to set the average crystal grain diameter into 100 nm or less. In the case of using, for example, pure Ag as the sputtering target, the substrate temperature (film-depositing temperature) is set preferably to a temperature lower than 150°C (more preferably to 100°C or lower, even more preferably to ambient temperature).

When the second layer is formed, the manner for depositing the sputtered thin film is not particularly limited and may be a manner of using a sputtering target of the above-mentioned metal(s) to deposit the film by sputtering. It is particularly preferred to deposit the film by DC sputtering using a direct-current cathode.

The metal(s) used to form the second layer is/are one or more elements that are easily oxidizable. Thus, the oxidization of the sputtered thin film can be attained by keeping the workpiece including this film in the atmospheric air over a long period (that is, natural oxidization). At this time, a long period is required for the oxidization of the sputtered thin film. Thus, in order to promote the oxidization, it is preferred to keep the workpiece therein while subjecting the workpiece to thermal treatment at a high temperature (that is lower than 150°C). Alternatively, it is allowable to perform a manner of holding the workpiece in an atmosphere higher in oxygen concentration than the atmospheric air (and optionally subjecting the workpiece to additional thermal treatment at a high temperature), or to oxidize the sputtered thin film by $O_2$ plasma treatment used in the production of a semiconductor, or some other treatment. From the viewpoint of production costs, it is most preferred to oxidize the thin film by thermal treatment in the atmospheric air.

When the plasma polymerized film is further formed over the second layer, the manner to be used may be a manner of forming the film by plasma CVD using, for example, hexamethyldisiloxane as a raw material.

When the resin film is formed instead of the plasma polymerized film, the manner to be used may be a manner of dipping or spray coating.

Examples

Hereinafter, the invention will be described in detail by way of working examples. However, the invention is not limited by the examples. Any example carried out with a modification or change of any one of the examples is included in the scope of the invention as far as the modified or changed example does not depart from the subject matters that have been described above and will be described below.

Production Examples 1 to 41

For each substrate, polycarbonate (PC) was used. As each sputtering target, use was made of a sputtering target having a diameter of 101.6 mm and a thickness of 5 mm, and made of pure Ag or an Ag-based alloy. First, a sputtering chamber was made into a vacuum to set the pressure therein to $1.3 \times 10^{-3}$ Pa or less. Next, Ar gas was introduced into the sputtering chamber to turn the pressure therein to $2.6 \times 10^{-1}$ Pa. A DC (direct current) power of 200 W was applied to its electrodes to generate plasma, thereby sputtering the sputtering target. In this way, a first layer was formed. The distance between the sputtering target and the substrate was set to 80 mm. The layer was formed while the PC substrate was revolved along an orbit. The temperature at the films in these examples were formed was set to ambient temperature except that the film-depositing temperature in Production Example 41 was set to 150°C.

In each of the thus-formed Ag-based alloy films, a method for measuring the respective average contents by percentage of individual added element species will be described later.

After the formation of the Ag film as the first layer, a second layer was formed by adjusting the pressure in the sputtering chamber to $2.6 \times 10^{-1}$ Pa without opening the sputtering chamber, sputtering a metal sputtering target at a DC power of 200 W, and next oxidizing the formed film. In the method for the oxidization, the workpiece was kept at ambient temperature in the atmospheric air (natural oxidization) for 12 hours or longer. The respective film thicknesses of the first and second layers were adjusted by controlling the respective sputtering periods.

By methods described below, each of Production Examples 1 to 41 was measured about the respective contents by percentage of various added elements, the average crystal grain diameter of the first layer (Ag film), and the visible ray reflectivity (the initial reflectivity) of the reflective film laminate, and the proportion of a decrease in the reflectivity. Moreover, under conditions described below, the reflective film laminate was caused to undergo a sulfurization resistance test and a heat resistance test.

<Respective contents by percentage of individual added element species>

The respective contents by percentages of the individual added element species in the Ag film were measured and determined by ICP (inductively coupled plasma) analysis. Specifically, an acid in which Ag and the added element species can be dissolved was used, and the total quantity of the Ag-based alloy film was dissolved therein. The quantities of Ag and the added element species in the resultant solution were measured by ICP emission spectroscopy, or ICP mass spectroscopy. These quantities were normalized into a proportion of 100% to calculate the composition (atomic percent) of the Ag-based alloy film.

<Average crystal grain diameter>

In order to evaluate the average crystal grain diameter of the Ag film, an AFM (atomic force microscope) was used. An observation was made about a viewing field having a size of 1 $\mu$m x 1 $\mu$m of the topmost surface of the Ag film formed on the PC substrate, and an image photograph was taken therefrom. The photograph was used to determine the grain diameter in accordance with a cutting method (JIS H 0501).

<Visible ray reflectivity (initial reflectivity)>

In accordance with a method described in JIS R 3106, the visible reflectivity (initial reflectivity) was measured by use of light rays having wavelengths in the range of 380 to 780 nm from a D65 light source.

<Proportion of a decrease in the reflectivity>

In accordance with a method described in JIS R 3106, about the first layer used in each of Production Example 1 to 41, the visible ray reflectivity (the initial reflectivity) was measured by use of light rays having wavelengths in the range of 380 to 780 nm from a D65 light source. Thereafter, the proportion of a decrease in the reflectivity was determined by use of the following equation:

$$\text{Proportion of the decrease in the reflectivity} = \text{"the visible ray reflectivity of only the first layer of each of Production Examples 1 to 41"} - \text{"the visible ray reflectivity of the reflective film laminate of each of Production Examples 1 to 41, which was a laminate after the second layer was formed"}$$

<Sulfurization resistance test>

Each of the reflective film laminates was set over a 10%-by-mass solution of ammonium sulfide in water and at a height of 3 cm from the solution surface to face its film surface (its second layer front surface) to the solution surface, and then exposed to the solution at ambient temperature (25°C) for 20 minutes.
About the reflective film laminate after the sulfurization test, its front surface (the surface exposed to the solution in the sulfurization test) was enlarged at a power of 200 magnifications by means of an optical microscope, and the surface was photographed. In a region (of the photograph) that had a size of 0.2 mm x 0.2 mm according to the dimension of a photograph of a micrometer that was taken at the same power (that is, a surface region having an actual size of 0.2 mm x 0.2 mm on the photographed surface), dot-form discoloration spots generated in the surface, i.e., sulfurization spots in the Ag film that were generated in pinhole sites of the oxide film were counted. In accordance with the number of the generated spots, the laminate was evaluated about the sulfurization resistance thereof (the degree that the laminate was less easily sulfurized). When this number of the generated spots was zero, the laminate was determined to be very good (◎); when the number was from 1 to 3, good (o); when the number was from 4 to 6, permissible (△); and when the number was 7 or more, poor (x).

<Heat resistance test>

Each of the reflective film laminates was put into a thermostat of 130°C temperature, and kept therein for 1000 hours.
About the reflective film laminate after the heat resistance test, the visible ray reflectivity was measured by use of light rays having wavelengths in the range of 380 to 780 nm from a D65 light source in accordance with JIS R 3106. A calculation was made about the difference thereof from the visible ray reflectivity (the initial reflectivity) measured in the same way before the heat resistance test [that is, the difference between the reflectivities before and after the test = "the initial reflectivity (%)" - "the reflectivity (%) after the heat resistance test"]. In accordance with this reflectivity difference, the laminate was evaluated about the heat resistance thereof (the degree that the Ag aggregation was less easily caused by heat). When this reflectivity difference was 0.5% or less, the laminate was determined to be very good (◎); when the difference was more than 0.5% and 1% or less, good (o); when the difference was more than 1% and 3% or less, permissible (△); and when the difference was more than 3%, poor (×).
TABLE 1

| Production Example | First layer | | Second layer | | | Reflectivity | | Endurance | | |
|---|---|---|---|---|---|---|---|---|---|---|
| | Ag film composition | Average crystal grain diameter (nm) | Film species | PB ratio | Film thickness (nm) | Initial reflectivity (%) | Proportion (%) of decrease in reflectivity | Sufunzation resistance resistarce | Heat resistance | |
| | | | | | | | | Evaluation | Reflectivity (%) after test | Evaluation |
| 1 | Ag-0.03 Bi | 55 | Zr | 1.50 | 4 | 96.6 | 0.2 | ○ | 95.8 | ○ |
| | Ag-0.1 Bi | 35 | Zr | 1.50 | 4 | 96.5 | 0.2 | ◎ | 96.3 | ◎ |
| 3 | Ag-0.05 Bi-D.1 Ge | 30 | Zr | 1.50 | 4 | 96.3 | 0.2 | ◎ | 96.0 | ◎ |
| 4 | Ag-0.05Bi-1.0Au | 30 | Zr | 1.50 | 4 | 95.8 | 0.2 | ◎ | 95.6 | ◎ |
| 5 | Ag-0.05 Bi-0.1 Ge-1.0 Au | 30 | Zr | 1.50 | 4 | 96.2 | 0.2 | ◎ | 96.0 | ◎ |
| 6 | Ag-0.05 Bi-0.1 Ge-1.0 Pt | 30 | Zr | 1.50 | 4 | 95.8 | 0.2 | ◎ | 95.5 | ◎ |
| 7 | Ag-0.05 Bi-0.1 Ge-1.0 Pd | 30 | Zr | 1.50 | 4 | 94.3 | 0.2 | ◎ | 94.0 | ◎ |
| 8 | Ag-0.05 Bi-0.1 Ge-1.0 Rh | 30 | Zr | 1.50 | 4 | 95.2 | 0.2 | ◎ | 94.8 | ◎ |
| 9 | Ag-0.05 Bi-0.1 Ge-1.0 Au | 30 | Cr | 1.76 | 4 | 93.2 | 3.2 | ◎ | 92.8 | ◎ |
| 10 | Ag-0.05 Bi-0.1 Ge-1.0 Au | 30 | Nb | 2.74 | 4 | 94.4 | 2.0 | ◎ | 94.0 | ◎ |
| 11 | Ag-0.05 Bi-0.1 Ge-1.0 Au | 30 | Hf | 1.62 | 4 | 92.9 | 3.5 | ○ | 92.6 | ◎ |
| 12 | Ag-0.05 Bi-0.1 Ge-1.0 Au | 30 | Ta | 2.33 | 4 | 94.4 | 2.0 | ◎ | 94.3 | ◎ |
| 13 | Ag-0.05 Bi-0.1 Ge-1.0 Au | 30 | V | 3.18 | 4 | 95.1 | 0.3 | ○ | 94.4 | ○ |

| Production Example | First layer | | Second layer | | | Reflectivity | | Endurance | | |
|---|---|---|---|---|---|---|---|---|---|---|
| | Ag film composition | Average crystal grain diameter (nm) | Film species | PB ratio | Film thickness (nm) | Initial reflectivity (%) | Proportion (%) of decrease in reflectivity | Sufunzation resistance resistarce | Heat resistance | |
| | | | | | | | | Evaluation | Reflectivity (%) after test | Evaluation |
| 14 | Ag-0.05 Bi-0.1 Ge-1.0 Au | 30 | Ni | 1.62 | 4 | 93.6 | 1.6 | ◎ | 93.3 | ◎ |
| 15 | Ag-0.05 Bi-0.1 Ge-1.0 Au | 30 | Mo | 3.27 | 4 | 94.1 | 1.8 | ○ | 93.2 | ○ |
| 16 | Ag-0.05 Bi-0.1 Ge-1.0 Au | 30 | W | 3.40 | 4 | 92.8 | 3.6 | ○ | 92.1 | ○ |
| 17 | Ag-0.05 Bi-0.1 Ge-1.0 Au | 30 | Al | 1.31 | 4 | 94.8 | 0.8 | ◎ | 93.9 | ○ |
| te 8 | Ag-0.05 Bi-0.1 Ge-1.0 Au | 30 | Si | 2.27 | 4 | 95.3 | 0.4 | ◎ | 94.6 | ○ |
| 19 | Ag-0.05 Bi-0.1 Ge-1.0 Au | 30 | Zr | 1.50 | 0.4 | 96.2 | 0.0 | ○ | 95.3 | ○ |
| 20 | Ag-0.05 Bi-0.1 Ge-1.0 Au | 30 | Zr | 1.50 | 8 | 85.2 | 11.2 | ◎ | 85.1 | ◎ |
| 21 | Ag-0.0 Bi-2.0 Cu | 30 | Zr | 1.50 | 4 | 95.6 | 0.6 | ◎ | 95.3 | ◎ |
| 22 | Ag-0.05 Bi-1.5 Sn | 30 | Zr | 1.50 | 4 | 94.8 | 0.6 | ◎ | 94.4 | ◎ |
| 23 | Ag-0.05 Bi-1.2 Al | 30 | Zr | 1.50 | 4 | 95.4 | 0.7 | ◎ | 95.1 | ◎ |
| 24 | Ag-0.05 Bi-1.5 Cr | 30 | Zr | 1.50 | 4 | 95.3 | 0.1 | ◎ | 95.1 | ◎ |
| 25 | Ag-0.05 Bi-1.3 V | 30 | Zr | 1.50 | 4 | 95.0 | 0.7 | ◎ | 94.4 | ○ |

EP 2 530 495 A1

(continued)

| Production Example | First layer | | Second layer | | | Reflectivity | | Sufunzation resistance resistance | Endurance | |
| | Ag film composition | Average crystal grain diameter (nm) | Film species | PB ratio | Film thickness (nm) | Initial reflectivity (%) | Proportion (%) of decrease in reflectivity | Evaluation | Heat resistance | |
| | | | | | | | | | Reflectivity (%) after test | Evaluation |
|---|---|---|---|---|---|---|---|---|---|---|
| 26 | Ag-0.05 Bi-1.5 Mo | 30 | Zr | 1.50 | 4 | 93.2 | 0.3 | ◎ | 93.0 | ◎ |
| 27 | Ag-0.05 Bi-1.0 Ru | 30 | Zr | 1.50 | 4 | 93.2 | 0.5 | ◎ | 92.7 | ◎ |
| 28 | Ag-0.05 Bi-1.2 Ir | 30 | Zr | 1.50 | 4 | 91.9 | 0.4 | ◎ | 91.5 | ◎ |
| 29 | Ag-0.05 Bi-1.0 Si | 30 | Zr | 1.50 | 4 | 90.5 | 0.3 | ◎ | 90.3 | ◎ |
| 30 | Ag-0.05 Bi-1.0 Cu-1.0 Al | 30 | Zr | 1.50 | 4 | 96.1 | 0.3 | ◎ | 95.6 | ◎ |
| 31 | Ag-0.05 Bi-1.0 Cu.1.0 Au | 30 | Zr | 1.50 | 4 | 95.6 | 0.2 | ◎ | 95.5 | ◎ |
| 32 | Ag-0.05 Bi-0.1 Ge-1.0 Cu | 30 | Zr | 1.50 | 4 | 94.1 | 0.3 | ◎ | 93.9 | ◎ |
| 33 | Ag-0.05 Bi-0.1 Ge-1.0 Au-1.0Cu | 35 | Zr | 1.50 | 4 | 93.9 | 0.2 | ◎ | 93.6 | ◎ |
| 34 | Ag | 80 | Zr | 1.50 | 4 | 96.6 | 0.2 | ○ | 95.7 | ○ |
| 35 | Ag-0.05 Bi-1.0 Au | 30 | Sn | 1.28 | 4 | 95.4 | 0.8 | ◎ | 92.5 | △ |
| 36 | Ag-0.05 Bi-1.0 Au | 30 | Ge | 1.23 | 4 | 94.3 | 1.2 | ◎ | 91.6 | △ |
| 37 | Ag | 140 | Zr | 1.50 | 4 | 96.6 | 0.2 | × | 91.1 | × |
| 38 | Ag-0.05 Bi-0.1 Ge-1.0 Au | 30 | Ta | 2.33 | 14 | 63.2 | 33.2 | ◎ | 62.9 | ◎ |

(continued)

| Production Example | First layer | | Second layer | | | Reflectivity | | Endurance | | |
|---|---|---|---|---|---|---|---|---|---|---|
| | Ag film composition | Average crystal grain diameter (nm) | Film species | PB ratio | Film thickness (nm) | Initial reflectivity (%) | Proportion (%) of decrease in reflectivity | Sufunzation resistance resistarce | Heat resistance | |
| | | | | | | | | Evaluation | Reflectivity (%) after test | Evaluation |
| 39 | Ag | 80 | Ta | 2.33 | 14 | 63.6 | 33.2 | ◎ | 63.4 | ◎ |
| 40 | Ag-0.05 Bi-0.1 Ge-1.0 Au | 30 | Zr | 1.50 | 20 | 58.1 | 38.3 | ◎ | 58.8 | ◎ |
| 41 | Ag | 80 | Zr | 1.50 | 20 | 59.4 | 37.4 | ◎ | 59 | ◎ |

(1) In each Ag film composition, a number (following each alloying-element) represents the added quantity (atomic percent) thereof.
(2) Therein, the balance was composed of Ag and inevitable impurities.

It is understood from Production Example 1 to 34 that in the reflective film laminate of the invention, the reflectivity is deteriorated by 30% or less by the laying of the second layer (in other words, the initial reflectivity thereof is high), and further the laminate has an excellent sulfurization resistance and heat resistance.

In contrast, it is understood from Production Example 35 or 36 that when the second layer is made of Sn or Ge, the laminate becomes poor in heat resistance.

It is understood from Production Example 4, and Production Examples 9 to 18, about which the former example was different from the latter examples only in second layer composition, that the reflective film laminate is better in sulfurization resistance when the second layer is made of any one of Zr, Cr, Nb, Ta and Ni than when the layer is made of Hf, V, Mo, W, Al or Si.

It is understood from a comparison between Production Examples 34 and 37 that even when the first layer is a pure Ag film and further the composition and the film thickness of the second layer are in the ranges specified in the invention, a reflective film laminate excellent in sulfurization resistance and heat resistance may not be obtained if the average crystal gain particle of the first layer is not controlled into 100 nm or less.

It is understood from Production Examples 38 to 41 that if the film thickness of the second layer is more than 10 nm, the deterioration in the reflectivity cannot be restrained to 30% or less by the laying of the second layer, so that a reflective film laminate poor in initial reflectivity is yielded.

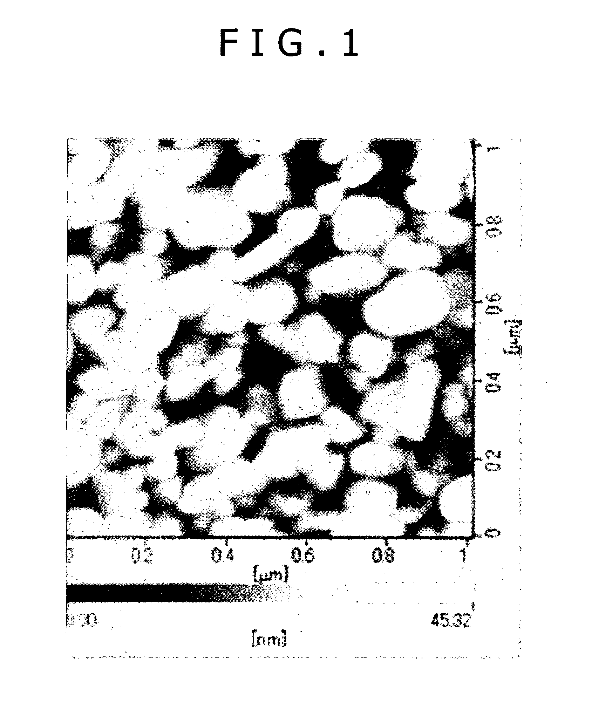

In Fig. 1 is shown an AFM (atomic force microscopic) image of the first layer yielded in Production Example 37; and in Fig. 2, an AFM image of the first layer yielded in Production Example 3. As shown in Fig. 2, when a first layer is formed which is made of an Ag-based alloy of fine crystals having an average crystal grain diameter of 100 nm or less according to the invention, an effect of sealing pinholes in the second layer (concerned) is exhibited, so that a good result is obtained.

The invention has been described in detail with reference of the specific embodiments. However, it is evident for those skilled in the art that various changes or modifications can be added thereto without departing from the spirit or the scope of the invention.

The present application is based on Japanese Patent Application (No. 2010-013492) filed on January 25, 2010, the contents of which are incorporated herein by reference.

Industrial Applicability

The invention is useful for supplying a reflective film laminate having a reflectivity that is not easily deteriorated by the aggregation of Ag atoms in its Ag film.

**Claims**

1. A reflective film laminate, comprising a substrate,
   a pure Ag film or an Ag-based alloy film as a first layer over the substrate, and
   an oxide film as a second layer laid over the first layer, the oxide film being an oxide film of one or more metals selected from the group consisting of Zr, Cr, Nb, Hf, Ta, V, Ni, Mo, W, Al and Si,
   wherein the second layer has a thickness of 0.1 to 10 nm, and further by the laying of the second layer, the reflectivity of the reflective film laminate is deteriorated by 30% or less.

2. The reflective film laminate according to claim 1, wherein the first layer has an average crystal grain diameter of 100 nm or less.

3. The reflective film laminate according to claim 1 or 2, wherein the first layer is an Ag-based alloy film comprising Bi in a proportion of 0.02 atomic percent or more.

4. The reflective film laminate according to claim 3, wherein the first layer is the Ag-based alloy film that further comprises Ge in a proportion of 0.02 atomic percent or more.

5. The reflective film laminate according to claim 3 or 4, wherein the first layer is the Ag-based alloy film that further comprises one or more selected from the group consisting of Au, Pt, Pd, and Rh in a proportion of 0.1 to 5 atomic percent.

6. The reflective film laminate according to any one of claims 3 to 5, wherein the first layer is the Ag-based alloy film that further comprises one or more selected from the group consisting of Cu, Sn, Al, Cr, V, Mo, Ru, Ir and Si in a proportion of 0.1 atomic percent or more.

7. The reflective film laminate according to any one of claims 3 to 5, wherein the first layer is the Ag-based alloy that further comprises one or more selected from the group consisting of Cu, Sn and Al in a proportion of 0.1 atomic percent or more.

8. The reflective film laminate according to any one of claims 1 to 7, which has, as the second layer, an oxide film of one or more metals selected from the group consisting of Zr, Cr, Nb, Ta and Ni.

9. The reflective film laminate according to any one of claims 1 to 8, which has a plasma polymerized film or a resin film as a third layer over the second layer.

10. A method for producing a reflective film laminate as recited in any one of claims 1 to 9, comprising the step of forming a first layer that is a pure Ag film or an Ag-based alloy film over a substrate, and
the step of using a sputtering target comprising one or more metals selected from the group consisting of Zr, Cr, Nb, Hf, Ta, V, Ni, Mo, W, Al and Si to perform sputtering over the first layer, thereby depositing a sputtered thin film, and next oxidizing the sputtered thin film in an atmosphere containing oxygen, thereby forming a second layer.

11. A lightening tool for a vehicle, comprising a reflective film laminate as recited in any one of claims 1 to 9.

12. An illuminator, comprising a reflective film laminate as recited in any one of claims 1 to 9.

13. An optical mirror, comprising a reflective film laminate as recited in any one of claims 1 to 9.

# F I G . 1

# FIG.2

# FIG.3

METAL OXIDE FILM  } SECOND LAYER

METAL FILM →  PURE Ag FILM, OR Ag-BASED ALLOY FILM  ← FIRST LAYER

## INTERNATIONAL SEARCH REPORT

| | International application No. |
| --- | --- |
| | PCT/JP2011/051337 |

**A. CLASSIFICATION OF SUBJECT MATTER**
*G02B5/08*(2006.01)i, *B32B15/01*(2006.01)i, *B32B15/04*(2006.01)i, *C23C14/14*(2006.01)i, *C23C14/58*(2006.01)i, *F21V7/22*(2006.01)i

According to International Patent Classification (IPC) or to both national classification and IPC

**B. FIELDS SEARCHED**

Minimum documentation searched (classification system followed by classification symbols)
G02B5/08, B32B15/01, B32B15/04, C23C14/14, C23C14/58, F21V7/22

Documentation searched other than minimum documentation to the extent that such documents are included in the fields searched
Jitsuyo Shinan Koho 1922–1996 Jitsuyo Shinan Toroku Koho 1996–2011
Kokai Jitsuyo Shinan Koho 1971–2011 Toroku Jitsuyo Shinan Koho 1994–2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2009-98650 A (Kobe Steel, Ltd.), 07 May 2009 (07.05.2009), | 1-5,8,9, 11-13 |
| Y | claims 1, 4, 6, 10 to 12; paragraphs [0003], [0025], [0029], [0046], [0063] & JP 2009-98650 A & US 2010/0195231 A & EP 2204674 A1 & WO 2009/041529 A1 & CN 101809467 A | 6,7,10 |
| X | JP 2005-250229 A (Asahi Glass Co., Ltd.), 15 September 2005 (15.09.2005), | 1,8 |
| Y | claims 1, 3; paragraph [0018] (Family: none) | 10 |

| ☒ Further documents are listed in the continuation of Box C. | | ☐ See patent family annex. |
| --- | --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 22 February, 2011 (22.02.11) | 08 March, 2011 (08.03.11) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2011/051337 |

C (Continuation). DOCUMENTS CONSIDERED TO BE RELEVANT

| Category* | Citation of document, with indication, where appropriate, of the relevant passages | Relevant to claim No. |
| --- | --- | --- |
| X<br>Y | JP 2003-016821 A (Mitsui Chemicals, Inc.),<br>17 January 2003 (17.01.2003),<br>claims 1, 4; paragraphs [0048] to [0051],<br>[0098]<br>& JP 2003-16821 A        & US 2002/0196628 A1<br>& EP 1253373 A2        & TW 243095 B<br>& KR 10-2002-0083439 A   & CN 1384393 A | 1,8,11-13<br>6,7,10 |
| X<br>Y | JP 1-279202 A (Mitsui Toatsu Chemicals, Inc.),<br>09 November 1989 (09.11.1989),<br>claim 1; page 3, upper left column, line 5 to<br>upper right column, line 11<br>(Family: none) | 1,8<br>10 |
| Y | JP 2007-248562 A (Shincron Co., Ltd.),<br>27 September 2007 (27.09.2007),<br>paragraph [0016]<br>(Family: none) | 10 |

Form PCT/ISA/210 (continuation of second sheet) (July 2009)

**EP 2 530 495 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000106017 A
- JP 2006098856 A
- JP 2008191528 A
- JP 2008233894 A
- JP 2009098650 A
- JP 2010013492 A